(19) **Europäisches Patentamt**
**European Patent Office**
**Office européen des brevets**

(11) **EP 3 994 736 B1**

(12) # EUROPÄISCHE PATENTSCHRIFT

(45) Veröffentlichungstag und Bekanntmachung des Hinweises auf die Patenterteilung:
**23.08.2023** **Patentblatt 2023/34**

(21) Anmeldenummer: **20734705.5**

(22) Anmeldetag: **23.06.2020**

(51) Internationale Patentklassifikation (IPC):
**H10N 30/00** *(2023.01)* **H10N 30/853** *(2023.01)*
**H10N 30/076** *(2023.01)*

(52) Gemeinsame Patentklassifikation (CPC):
**H10N 30/1051; H10N 30/076; H10N 30/8554**

(86) Internationale Anmeldenummer:
**PCT/EP2020/067568**

(87) Internationale Veröffentlichungsnummer:
**WO 2021/004782 (14.01.2021 Gazette 2021/02)**

(54) **HALBLEITERBAUELEMENT MIT DIELEKTRISCHER SCHICHT**

SEMICONDUCTOR COMPONENT WITH DIELECTRIC LAYER

COMPOSANT SEMICONDUCTEUR COMPORTANT UNE COUCHE DIÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **05.07.2019 DE 102019209964**
**05.07.2019 DE 102019209965**
**08.07.2019 DE 102019210033**
**08.07.2019 DE 102019210032**

(43) Veröffentlichungstag der Anmeldung:
**11.05.2022 Patentblatt 2022/19**

(73) Patentinhaber: **Robert Bosch GmbH**
**70442 Stuttgart (DE)**

(72) Erfinder:
• **SCHATZ, Frank**
**70806 Kornwestheim (DE)**
• **SCHARY, Timo**
**72631 Aichtal-Neuenhaus (DE)**
• **MONTEIRO DINIZ REIS, Daniel**
**73734 Esslingen Am Neckar (DE)**
• **PANTEL, Daniel**
**71254 Ditzingen (DE)**
• **TOMASCHKO, Jochen**
**71126 Gaeufelden (DE)**
• **MEWS, Mathias**
**72766 Reutlingen (DE)**

(56) Entgegenhaltungen:
**EP-A1- 3 306 687** **JP-A- 2020 012 159**

**US-A1- 2011 074 889**

• **CHAKRABORTI P ET AL: "XPS depth profiling and leakage properties of anodized titania dielectrics and their application in high-density capacitors", JOURNAL OF MATERIAL SCIENCE, Bd. 50, Nr. 23, 6. August 2015 (2015-08-06), Seiten 7600-7609, XP035547978, ISSN: 0022-2461, DOI: 10.1007/S10853-015-9320-6**
• **CHENTIR M T ET AL: "Electrical Characterization and Reliability of Lanthanum Doped PZT Thin Films Capacitors", INTEGRATED FERROELECTRICS, Bd. 96, Nr. 1, 2008, Seiten 75-81, XP055729892, ISSN: 1058-4587, DOI: 10.1080/10584580802100960**
• **BOUYSSOU E ET AL: "Wafer level reliability and leakage current modeling of PZT capacitors", MATERIALS SCIENCE AND ENGINEERING B, Bd. 118, Nr. 1-3, 25. April 2005 (2005-04-25), Seiten 28-33, XP027792073, ISSN: 0921-5107, DOI: 10.1016/j.mseb.2004.12.056**
• **MONTEIRO DINIZ REIS D ET AL: "Leakage Current in Low-Temperature PVD PZT Films", 2019 IEEE INTERNATIONAL SYMPOSIUM ON APPLICATIONS OF FERROELECTRICS, 14-19 JULY 2019, LAUSANNE, SWITZERLAND, 14. Juli 2019 (2019-07-14), Seiten 1-4, XP033740285, DOI: 10.1109/ISAF43169.2019.9034930**

EP 3 994 736 B1

**Beschreibung**

Stand der Technik

Die Erfindung betrifft ein Halbleiterbauelement.

In "Improved reliability predictions in high permittivity dielectric oxide capacitors under high dc electric fields with oxygen vacancy induced electromigration" von C. A. Randall, R. Maier, W. Qu, K. Kobayashi, K. Morita, Y. Mizuno, N. Inoue und T. Oguni aus dem Journal of Applied Physics 113, 014101 (2013) wird als Grund für den Durchbruch in einer dielektrischen Schicht das Hopping einer in einer dielektrischen Schicht vorliegenden Defektart, wie beispielsweise Sauerstofffehlstellen, beschrieben. Die zentralen Modellparameter werden hierbei physikalisch motiviert aber empirisch durch Fit an die Ausfallzeit unter der Annahme nur einer aktiven Defektart ermittelt. Wie diese Parameter genauer mit dem Material zusammenhängen wird nicht beschrieben. Komplexe Ausfallmechanismen, bei denen in der Halbleiterschicht mehrere Defektarten vorliegen, werden hierbei unvollständig oder überhaupt nicht abgebildet. Die dort beschriebene Lebensdauervorhersage gilt nur, wenn eine Defektart bei einem vorliegenden Lastfall mit einer bestimmten Temperatur und einem bestimmen elektrischen Feld dominiert und das Versagen auch ausschließlich durch die Anhäufung dieser einen Defektart an eine Grenzschicht verursacht wird.

In "Highly accelerated lifetime testing of potassium sodium niobate thin films" von Wanlin Zhu, Betul Akkopru-Akgun und Susan Trolier-McKinstry aus dem Applied Physics Letters 111, 212903 (2017) werden weiterhin typische Ausfallhäufigkeiten über der Betriebszeit für diverse Betriebsbedingungen bestimmt. Hieraus ist ersichtlich, dass sich der Ausfallmechanismus im Material über die getesteten Betriebsbedingungen oder sogar bei einer bestimmten Betriebsbedingung innerhalb einer Probengruppe unterscheidet. Es sind jedoch darüber hinaus aufgrund der empirischen Modelle keine Verbindungen zu physikalischen, elektrischen oder chemischen Vorgängen im Material ableitbar.

P Chakraborti et al, "XPS depth profiling and leakage properties of anodized titania dielectrics and their application in high-density capacitors", J. Mater. Sei. 50:7600-7609 (2015) sowie US 2011/074889 A1 und EP 3 306 687 A1 offenbaren exemplarische Halbleiterbauelemente mit mehreren verschiedenen Defektarten in dielektrischen Schichten, insbesondere Ti- und O-Defekte in $TiO_2$ bzw. Pb- und O-Defekte in PZT-Schichten.

Es ist eine Aufgabe der vorliegenden Erfindung, die Lebensdauer eines Halbleiterbauelements mit mehr als einer aktiven Defektart in Abhängigkeit der vorgesehenen Hauptbetriebsspannung und Hauptbetriebstemperatur des Halbleiterbauelements zu optimieren.

Offenbarung der Erfindung

Zur Lösung der Aufgabe wird ein Halbleiterbauelement gemäß Anspruch 1 vorgeschlagen. Ein solches Halbleiterbauelement wird mit Hilfe von Dünnschichttechnologien auf Siliziumsubstraten hergestellt und kann beispielsweise als piezoelektrischer Aktor bei MEMS-Bauteilen, wie zum Beispiel Mikrospiegeln verwendet werden. Hierbei weist das Halbleiterbauelement wenigstens eine dielektrische Schicht auf. Außerdem weist das Halbleiterbauelement wenigstens eine erste und eine zweite Elektrode auf, über welche eine Hauptbetriebsspannung an die dielektrische Schicht angelegt wird. Die Hauptbetriebsspannung ist gemäß der Spezifikation des Halbleiterbauteils die höchste zulässige Potentialdifferenz an den beiden Elektroden des Halbleiterbauelements im aktiven Betrieb. In der dielektrischen Schicht liegen außerdem wenigstens zwei voneinander unterschiedliche Defektarten mit vor. Diese können Fehlstellen (z.B. Sauerstoff- oder Bleifehlstellen), Gitterstörung durch besetzte Zwischengitterplätze (z.B. durch Wasserstoff), Frenkel-Defekte, aber auch substitutionelle Defekte (z.B. durch beabsichtigt oder unbeabsichtigt eingebrachte Fremdatome) sein. Diese Defektarten unterscheiden sich beispielsweise in ihrer elektrischen Ladungszahl voneinander. Einer ersten Defektart ist eine erste elektrische Ladung $N_{q,1}$ und eine erste material- und defektabhängige wahre Aktivierungsenergie $E_{A,0,1}$ zugeordnet. Einer zweiten Defektart ist eine zweite elektrische Ladung $N_{q,2}$ und eine zweite wahre Aktivierungsenergie $E_{A,0,2}$ zugeordnet. Die wenigstens zwei unterschiedlichen Defektarten sammeln sich in Abhängigkeit einer zwischen der ersten und zweiten Elektrode angelegten Hauptbetriebsspannung und einer vorliegenden Hauptbetriebstemperatur in charakteristischen Zeiten $\tau_1$ und $\tau_2$ an einer Grenzschicht der beiden Elektroden an und erzeugen an den Elektroden die maximalen Barrierenhöhenänderungen $\delta\Phi_1$ und $\delta\Phi_2$. Die Hauptbetriebstemperatur ist gemäß der Spezifikation des Halbleiterbauteils die höchste zulässige Temperatur im aktiven Betrieb. $\tau_1$ und $\delta\Phi_1$ sind der ersten Defektart und $\tau_2$ und $\delta\Phi_2$ der zweiten Defektart zugeordnet. Je höher die maximalen Barrierenhöhenänderung $\delta\Phi_1$ und $\delta\Phi_2$ und je kleiner die $\tau_1$ und $\tau_2$ der entsprechenden Defektart sind, desto schneller wird die kritische Barrierenhöhenänderung $\Delta\phi_{krit}^{+/-}$ an einer der Grenzschichten zwischen der dielektrischen Schicht und den Elektroden erreicht und es kommt zum dielektrischen Durchbruch. Bei dem Halbleiterbauelement gemäß Anspruch 1 gilt, dass $\tau_2$ größer ist als $\tau_1$. Das bedeutet, dass die zweite Defektart im Vergleich zu der ersten Defektart grundsätzlich länger benötigt, um sich innerhalb der dielektrischen Schicht zu einer Elektrode hin zu bewegen und sich an einer Grenzschicht der Elektrode anzusammeln. Es gilt jedoch zudem, dass $\delta\Phi_1 < \delta\Phi_2$ und somit die durch die zweite Defektart erzeugte maximale Barrierenhöhenänderung $\delta\Phi_2$ größer ist, als die durch die erste Defektart erzeugte maximale Barrierenhöhenänderung $\delta\Phi_1$. Somit erreicht also zunächst eine Defektart die Grenzschicht, welche vergleichsweise einen geringeren Einfluss auf den elektrischen Durchbruch der dielektrischen Schicht hat. Der Effekt der sich hieraus ergibt ist, dass die kritische Barrierenhöhenänderung $\Delta\Phi_{krit}^{+/-}$ der Elektrode erst zeitlich später erreicht wird und somit eine längere Lebensdauer unter den Betriebsbedingungen für welches das Halbleiterbauelement ausgelegt wurde, erreicht wird.

Die maximalen Barrierenhöhenänderungen $\delta\Phi_i$ können beispielsweise im Abscheideprozess der dielektrischen Schicht durch die Wahl der Ausgangsmaterialien beeinflusst werden. Beispielsweise kann im Falle einer PZT-Schicht Blei-, Zirkon- und/oder Titanmangel oder -überschuss durch die Zusammensetzung im Ausgangsmaterial eingestellt werden. Dies bedeutet, dass für den Fall einer Sputter-Abscheidung die Wahl des Target-Materials und für den Fall von Solgel-Abscheidungen die Auswahl der Precursor-Sole von Bedeutung sein kann. So können beispielhaft mit Bleifehlstellen assoziierte $\delta\Phi_i$ durch die Erhöhung des Bleigehaltes im Target oder der Precursor-Sole über eine stöchiometrische Zusammensetzung hinaus verkleinert werden. Im Gegensatz dazu können beispielhaft mit Bleiüberschuss assoziierte $\delta\Phi_i$ durch die Reduktion des Bleigehaltes im Target oder der Precursor-Sole verkleinert werden.

Des Weiteren können die maximalen Barrierenhöhenänderungen $\delta\Phi_i$ beispielsweise über Prozessparameter bei der Abscheidung verändert werden. So kann es beispielsweise über höhere Temperaturen im PZT-Sputterprozess zu Ausgasungen von Blei kommen, was zu einer Reduzierung des Bleigehalts in der Schicht führt. Damit könnten mit Bleifehlstellen assoziierte $\delta\Phi_i$ durch die Reduktion der Prozesstemperatur im PZT-Sputterprozess verkleinert werden.

Auch die beteiligten Prozessgase können genutzt werden um Defektspezies zu beeinflussen. Sauerstofffehlstellen sind beispielsweise eine bekannte Defektart bei PZT-Schichten. Die Menge der im Material vorhandenen Sauerstofffehlstellen kann unter anderem durch Veränderung des Sauerstoffpartialdruckes während einer PZT-Sputterabscheidung beeinflusst werden. So könnten beispielhaft mit Sauerstofffehlstellen assoziierte $\delta\Phi_i$ durch Hinzufügen eines Sauerstoffflusses verkleinert werden.

Für die Passivierung und Kontaktierung eines Halbleiterbauelements werden häufig Folgeprozesse benötigt. Des Weiteren sind häufig Folgeprozesse für die Herstellung anderer Bauteile auf dem gleichen Substrat notwendig. Diese Folgeprozesse können einen sehr großen Einfluss auf die elektrische Lebensdauer eines Halbleiterbauelements haben. Dringt Wasserstoff aus Folgeprozessen in das Bleioxidgefüge des PZTs ein, so kann der Sauerstoff das Bleioxid reduzieren. Dies erzeugt eine Sauerstofffehlstelle zusammen mit ausgasendem $H_2O$ bzw. OH-Stellen oder es entstehen mobile Wasserstoffionen im Gefüge. Die Reduktion des Wasserstoffgehaltes in Folgeprozessen wie z.B. der Abscheidung von Passivierungen in Wasserstoff haltigen Plasmaprozessen führt zu einer Reduktion von den Sauerstofffehlstellen bzw. Wasserstoffionen zugeordneten $\delta\Phi_i$. In solchen Prozessen kann beispielsweise der Wasserstoffgehalt durch die Verwendung eines Wasserstoff ärmeren Precursors, wie beispielsweise durch die Verwendung von $N_2$ als Stickstoffquelle anstatt $NH_3$ bei der Abscheidung einer PECVD-SiN Passivierung reduziert werden. Eine weitere Möglichkeit der Reduktion von Wasserstoff in der Abscheidung von PECVD-Passivierungen ist beispielhaft die Reduktion der Gasflüsse eines Wasserstoff haltigen Precursors, um eine Reduktion von den Sauerstofffehlstellen bzw. Wasserstoffionen zugeordneten $\delta\Phi_i$ zu erreichen.

Durch geeignete Wahl der Folgeprozesse und/oder aber auch durch Wasserstoffbarrieren, welche das Dielektrikum umhüllen, kann Einfluss auf die Defektmenge und/oder den Sauerstofffehlstellen und/oder Wasserstoffionen zugeordneten $\delta\Phi_i$ genommen werden. Die Umhüllung des PZT mit einer Wasserstoffbarriere (z.B. gesputterter Metalloxide: RuO, TiO, AlOx) führt ebenfalls zu einer Reduktion der den Sauerstofffehlstellen bzw. Wasserstoffionen zugeordneten $\delta\Phi_i$. Eine weitere Möglichkeit zur Reduktion von durch Wasserstoff verursachten Materialschädigungen ist die Verringerung der Temperaturen und/oder der Dauer von Temperaturschritten in den Folgeprozessen, um weniger Energie für die Reaktion mit der dielektrischen Schicht bereit zu stellen. Dies führt zu einer Reduktion der den Sauerstofffehlstellen bzw. Wasserstoffionen zugeordneten $\delta\Phi_i$.

In einem weiteren Beispiel können bei bekannt dominanten Sauerstofffehlstellen im dielektrischen Material Temperaturschritte in Sauerstoffatmosphäre vorgesehen werden. Das nachträglich Einbringen von Sauerstoff in ein Gefüge mit Sauerstofffehlstellen führt zu einer Reduktion der den Sauerstofffehlstellen zugeordneten $\delta\Phi_i$.

Beispielsweise kann das Kriterium, wonach gilt $\tau_1 < \tau_2$ und $\delta\Phi_1 < \delta\Phi_2$ erreicht werden, indem die dielektrische Schicht derart mit wenigstens einer weiteren Defektart dotiert wird, dass für die maximalen Barrierenhöhenänderungen am Kontakt zwischen dielektrischer Schicht und Elektrode gilt $\delta\Phi_1 < \delta\Phi_2$. Hiermit kann die energetische Struktur im Materialinneren verändert werden. So können beispielsweise für eine existierende, störende Defektart a, die ein vergleichbar kleines $\tau_1$ und großes $\delta\Phi_1$ aufweist, neue zuvor nicht vorhandene tiefere lokalisierte Defektzentren, also mit einem tieferen lokalen Minimum der potentiellen Energie erzeugt werden. Somit kann die Mobilität der störenden Defektart a reduziert werden. Das Einbringen der weiteren Defektart kann hierbei durchaus zu einer weiteren großen maximalen Barrierehöhenabsenkung $\delta\Phi_3$ führen. Vorzugsweise findet diese Absenkung für die entsprechende Hauptbetriebsbedingung jedoch erst zu einem Zeitpunkt nach dem elektrischen Versagen der dielektrischen Schicht zum Zeitpunkt $t_{krit}$ statt. Der Grund hierfür ist, dass die beteiligte weitere Defektart eine so große charakteristische Zeitkonstante $\tau_3$ hat, dass sie sich bis zum Versagen des Bauteiles nicht an einer Grenzschicht der Elektroden ansammeln kann.

In den Ausgangsmaterialien können auch unbeabsichtigt durch Kontaminationen Defekte eingebracht sein, welche durch die Erhöhung des Reinheitsgrades der Ausgangsmaterialien, beispielsweise des Targets beim Sputtern oder der Precursor Solen im Solgelverfahren, reduziert werden können. Die Reduktion von Fremdstoffen (z.B. Eisen, Chlor) im Gefüge der dielektrischen Schicht reduziert somit die mit diesen Defekten assoziierten $\delta\Phi_i$.

Bei Dominanz von feldaktivierten Defekten gegenüber thermisch aktivierten Defekten ist eine Erhöhung der Dicke der dielektrischen Schicht eine weitere Möglichkeit die Reihenfolge im Defektgefüge zu verändern. Die Dicke der dielektrischen Schicht zu erhöhen, bietet beispielsweise speziell für den Fall piezoelektrischer Aktoren mit PZT eine Möglichkeit, bei gleichbleibender Aktorkraft die Lebensdauer zu erhöhen, da ein kleines elektrisches Feld alle Zeitkonstanten $\tau_i$ der beteiligten i Defektarten erhöht.

Ein Halbleiterbauelement gemäß Anspruch 1 zeigt über den Belastungszeitraum bis zum dielektrischen Versagen einen zeitlichen Verlauf der Leckstromdichte $J_{TED}$, welche über die Gleichung der Thermionic-Emission-Diffusion Theorie nach Crowell and Sze

$$J_{TED} = \frac{q \cdot N_C \cdot v_R}{1 + \frac{v_R}{v_D}} \cdot e^{-\frac{\Phi_B^{eff}}{k_B \cdot T}} \cdot \left[ e^{\frac{q \cdot U}{k_B \cdot T}} - 1 \right] \qquad (1)$$

beschrieben wird. Hierbei repräsentiert q die Einheitsladung, $N_C$ die effektive Zustandsdichte im Leitungsband, $v_R$ die effektive Rekombinationsgeschwindigkeit, $v_D$ die effektive Diffusionsgeschwindigkeit, $\phi_B^{eff}$ die effektive Schottky-Barriere, $k_B$ die Boltzmannkonstante, T die Umgebungstemperatur, und U die Potentialdifferenz über die dielektrische Schicht. U bedeutet in diesem Zusammenhang die an den beiden Elektroden des Halbleiterbauelements angelegte Hauptbetriebsspannung.

Verursacht wird der zeitliche Verlauf der Leckstromdichte durch die Veränderung der effektiven Schottky-Barriere $\phi_B^{eff}(t)$. Diese Veränderung oder Schottky-Barriere $\phi_B^{eff}(t)$ charakterisiert den Einfluss der beiden Grenzschichten, welche sich zwischen den beiden Elektroden und der dielektrischen Schicht befinden, auf die Leckstromdichte. Die effektive Schottky-Barriere wird im Folgenden kurz als $\phi(t)$ bezeichnet und beinhaltet alle Anteile von Halbleiter-Elektrodenmaterialübergang, Veränderungen durch die angelegte Hauptbetriebsspannung und Veränderungen durch Anlagerung von Defekten. Der Logarithmus der Leckstromdichte reduziert Gleichung (1) auf eine zeitliche Konstante K und einen zeitlich veränderlichen Term, der die Vorgänge im Materialinneren wiederspiegelt, die durch die Bewegungen aller mobilen im Material enthaltenen Defekte verursacht werden:

$$\ln(J_{TED}(t)) = \ln(K) - \frac{\Phi(t)}{k_B \cdot T}. \qquad \text{mit} \quad K = \frac{q \cdot N_C \cdot v_R}{1 + \frac{v_R}{v_D}} \cdot \left[ e^{\frac{q \cdot U}{k_B \cdot T}} - 1 \right] \qquad (2.1)$$

Die Bezeichnung Defekt schließt hierbei auch strukturelle Änderungen im Gefüge mit ein.

Die Verschiebung der Defekte führt bei Annäherung an die Elektroden zu Defektanhäufungen in der dielektrischen Schicht, welche in Veränderungen der effektiven Barrierenhöhe resultieren. Gleichung 2.1 aufgelöst nach $\phi$ führt zu

$$\Phi(t) = [\ln(K) - \ln(J_{TED}(t))] k_B T \qquad (2.2)$$

Dieser zeitliche Verlauf der effektiven Barrierenhöhe infolge der Anlagerung von Defekten wird durch den Ansatz

$$\phi(t) = \phi^+(t) + \phi^-(t) = \phi_0^+ + \sum_i \Delta\phi_i^+(t) + \phi_0^- + \sum_i \Delta\phi_i^-(t) \qquad (3.1)$$

$$\phi(t) = \phi_0 + \sum_i \Delta\phi_i^+(t) + \sum_i \Delta\phi_i^-(t) \qquad \text{mit } \phi_0 = \phi_0^+ + \phi_0^- \qquad (3.2)$$

beschrieben. Es finden hierbei im Allgemeinen Anlagerungen und damit verbundene Veränderungen der effektiven Schottky-Barriere an beiden Grenzschichten $\phi^+(t)$ und $\phi^-(t)$ statt. Die Indizes + und - kennzeichnen hierbei jeweils die Veränderungen an der Grenzschicht, welche den Übergang von Minoritärs- bzw. Majoritätsladungsträger in die dielektrische Schicht charakterisiert. Die Grenzschichten haben eine Ausgangsbarrierenhöhe $\phi_0$ und erfahren Barrierenhöhenänderungen $\Delta\phi_i$, verursacht durch eine Defektart i. Aufgrund der notwendigen Ladungsneutralität muss es immer Defektpaare beziehungsweise Defektansammlungen geben. Das heißt, dass bei dem Auftreten von Defekten mit negativer Ladung ebenso Defekte mit positiver Ladung im Material existieren. Deren jeweiligen Wirkungen sind über die Indizes + und - gekennzeichnet. Die Einzeldefekte bewegen sich im angelegten elektrischen Feld der Hauptbetriebsspannung entsprechend ihrer Ladung in entgegengesetzter Richtung. Defekte mit positiver Ladung wandern zur Elektrode mit negativem Potential und lagern sich in deren Nähe in der dielektrischen Schicht an. Defekte mit negativer Ladung bewegen sich zur Elektrode mit positivem Potential, um sich wiederum in deren Nähe anzulagern.

Die Barrierenhöhenänderung $\Delta\phi_i$, welche durch Defektart i erzeugt wird, ist gekennzeichnet durch ihre Maximalhöhe $\delta\phi_i$ und einer charakteristischen Zeitkonstanten $\tau_i$, in welcher sich die Barrierenhöhenänderung am stärksten verändert:

$$\Delta\phi_i^{+/-}(t) = \delta\phi_i^{+/-}\left(1 - e^{\frac{t}{\tau_i^{+/-}}}\right). \tag{4}$$

$\delta\phi_i$, ist dabei im Allgemeinen eine Funktion der Defektanzahl $Z_i$, hängt jedoch zusätzlich von der Art der Grenzschicht ab. Die Wirkung der Defektanzahl kann nicht verallgemeinert werden, da bereits durch Anlagerung einer Monolage eine signifikante Barrierenhöhenänderungen $\Delta\phi_i$ resultieren kann. Daher ist für Materialien nach Anspruch 1 allein $Z_i > 0$

entscheidend. Der Term ( $1 - e^{\frac{t}{\tau_i^{+/-}}}$ ) stellt in der obigen Formel eine Näherung für die statistische Anlagerung einer im Material gegebenen Defektverteilung dar. Hierbei haben die positiven und negativen Maximalhöhen der Barrierenänderung $\delta\phi_i^+$ und $\delta\phi_i^-$ und die dazugehörigen Zeitkonstanten $\tau_i^+$ und $\tau_i^-$ unterschiedliche Größen, da es sich um unterschiedliche Defekte und bekannterweise unterschiedliche Grenzschichten handelt. Dies führt mit Formel (3.2) zu

$$\phi(t) = \phi_0 + \sum_i \delta\phi_i^{+/-}\left(1 - e^{\frac{t}{\tau_i^{+/-}}}\right) \tag{5}$$

bzw. für den zeitlich veränderlichen Teil der Barrierenänderung zu

$$\Delta\phi(t) = \sum_i \delta\phi_i^{+/-}\left(1 - e^{\frac{t}{\tau_i^{+/-}}}\right) \tag{5.1}$$

Die Zeitkonstant $\tau_i^{+/-}$, wird durch die Mobilität der Defekte in der dielektrischen Schicht und den zurückzulegenden Weg in dieser Schicht definiert. Bei der Verlagerung im Inneren der dielektrischen Schicht muss Defektart i den Abstand $d_i$ des Schwerpunktes seiner Verteilung zur Grenzschicht zurücklegen. Zusammen mit Geschwindigkeit $v_i$ resultiert die charakteristische Zeitkonstante für den Anlagerungsprozess der Defektart i in

$$\tau_i = \frac{d_i}{v_i} \tag{6}$$

Halbleiterbauelemente gemäß Anspruch 1 zeichnen sich durch eine Verlagerung der Defekte im angelegten elektrischen Feld der Hauptbetriebsspannung über Hopping aus. Die Defektart i bewegt sich entlang lokalisierter Defektzustände mit einem mittleren effektiven Abstand $a_i$. Dies führt zu einer Hopping-Geschwindigkeit $v_i$, welche über den bekannten Ansatz von Variable Range Hopping beschrieben wird:

$$v_i = C_{0,i}(a_i)\, e^{-\frac{E_{A,0,i}}{k_B T}} \sinh\left(\frac{N_{q,i}\, a_i\, E}{k_B T}\right) \qquad \text{mit } E = \frac{U}{d} \tag{7}$$

$$C_{0,i}(a_i) = v_0\, a_i\, e^{-\frac{2\, a_i}{\alpha}} \tag{7.1}$$

Hierbei repräsentiert $C_{0,i}(a_i)$ eine Funktion, die den Einfluss der örtlichen Defektverteilung darstellt. Hierbei bezeichnet, wie bei Variable Range Hopping üblich, die Sprungversuchsfrequenz $v_i$ die Frequenz, mit der ein Defekt gegen vorhandene Potentialbarrieren anläuft. Weiterhin ist die Sprungwahrscheinlichkeit des Defektes proportional dem Überlappintegral $e^{-\frac{2\,a_i}{\alpha}}$ der Wellenfunktionen zweier wasserstoffartiger lokalisierter Defekte mit Abklinglänge $\alpha$ im Abstand $a_i$ der lokalisierten Defektzustände.

Hierbei repräsentiert $C_{0,i}(a_i)$ eine Funktion, die den Einfluss der örtlichen Defektverteilung darstellt. Die mit der Betriebstemperatur zunehmende Hopping-Wahrscheinlichkeit wird über den Exponentialterm mit der material- und defektabhängigen wahren Aktivierungsenergie $E_{A,0,i}$ berücksichtigt. Die wahre Aktivierungsenergie $E_{A,0,i}$ bezeichnet hierbei eine von der Betriebsspannung und Betriebstemperatur unabhängige Aktivierungsenergie. Der Term $\exp(-E_{A,0,i}/(k_B T))$ wird mit wachsender Hauptbetriebstemperatur und gleichzeitig sinkender Hauptbetriebsspannung dominant. Das bedeutet, dass unter diesen Betriebsbedingungen Defektarten mit großer wahrer Aktivierungsenergie und geringer Ladung zum elektrischen Versagen des Halbleiterbauelements beitragen. Die gerichtete Absenkung der Energiebarrieren im Hopping-Prozess beschreibt der Sinus hyperbolicus, welcher das Produkt aus der mit dem Defekt i assoziierten Ladung $N_{q,i}$, dem mittleren lokalisierten Defektzentrenabstand $a_i$ und dem elektrischen Feld E enthält. Das elektrische Feld E resultiert aus angelegter Hauptbetriebsspannung U und der Dicke d der dielektrischen Schicht. Der Term $\sinh(N_{q,i}\,a_i\,E / (k_B T))$ gewinnt Einfluss bei wachsenden Hauptbetriebsspannungen und fallenden Hauptbetriebstemperaturen. Hier tragen Defektarten mit hoher Ladungszahl und gleichzeitig geringer wahrer Aktivierungsenergie zum elektrischen Versagen des Halbleiterbauelements bei.

Bei einem Halbleiterbauelement bewegen sich die in der dielektrischen Schicht enthaltenen n Defektarten über lokalisierte Defektzustände mit gleichem mittleren Abstand $a_0$. Somit gilt:

$$a_1 = a_2 \; ... = a_n = a_0 \tag{8}$$

Dieser Abstand der lokalisierten Defektzustände lässt sich mit Kenntnis der zuvor beschriebenen physikalischen Modellierung aus Leckstrommessdaten $J_{TED}$ extrahieren. Der mittlere effektive Abstand $a_0$ stellt für das dielektrische Versagen unter Temperatur- und Spannungsbelastung eine zentrale Materialeigenschaft dar. Diese Materialeigenschaft ist unabhängig von Betriebsspannung und Betriebstemperatur und kann über den Herstellungsprozess beeinflusst werden

Durch Kenntnis der zuvor beschriebenen physikalischen Modellierung können für die beteiligten i Defektarten die Ladung $N_{q,i}$ und die wahre Aktivierungsenergie $E_{a,0,i}$ aus Leckstrommessdaten $J_{TED}$ bestimmt werden. Des Weiteren kann für einen Betriebszustand der zugeordnete zeitliche Verlauf der Barrierenabsenkung $\Delta\phi_i$ ermittelt werden. Dieser zeitliche Verlauf der Barrierenabsenkung $\Delta\phi_i$ wird durch die charakteristische Zeitkonstante $\tau_i$, in welcher sich die Barrierenhöhenänderung $\Delta\phi_i$ am stärksten verändert und deren maximale Barrierenhöhenabsenkung $\delta\phi_i$ beschrieben. Mit Kenntnis der Ladung $N_{q,i}$ und der wahren Aktivierungsenergie $E_{a,0,i}$ können die Defektarten über verschiedene Betriebszustände hinweg identifiziert und ihrer nach Betriebszustand abweichenden Wirkung $\Delta\phi_i$ zugeordnet werden. Somit kann für Halbleiterbauelemente der Betriebszustand identifiziert werden, mit welchem eine lange Lebensdauer erreicht werden kann. Dieser zeichnet sich dadurch aus, dass schnellere Defektarten mit Zeitkonstanten $\tau_i$ kleiner der Ausfallzeit $t_{krit}$ vergleichbar kleine maximale Barrierehöhenabsenkungen $\delta\phi_i$ aufweisen.

Bei Halbleiterbauelementen existieren für die beiden Grenzschichten kritische Barrierenhöhenänderungen $\Delta\phi_{krit}^{+/-}$. Wird eine dieser kritischen Barrierenhöhenänderungen $\Delta\phi_{krit}^{+/-}$ lokal zum Zeitpunkt $t_{krit}$ erreicht bzw. überschritten, findet der dielektrische Durchbruch lokal statt. Das bedeutet, dass beim Erreichen von $\phi_{krit}^+$ der Durchbruch durch tunnelnde Minoritätsladungsträger (Fall 1) erfolgt:

$$\phi_{krit}^{+} = \phi_0^+ + \Sigma_i\,\Delta\phi_i^+\,(t_{krit}) = \phi_0^+ + \Delta\phi_{krit}^+ \quad mit\;\Delta\phi_{krit}^+ = \Sigma_i\,\Delta\phi_i^+\,(t_{krit}) \tag{9.1}$$

Beim Erreichen von $\phi_{krit}^-$ erfolgt der Durchbruch dagegen durch tunnelnde Majoritätsladungsträger (Fall 2):

$$\phi_{krit}^{-} = \phi_0^- + \Sigma_i\,\Delta\phi_i^-\,(t_{krit}) = \phi_0^- + \Delta\phi_{krit}^- \quad mit\;\Delta\phi_{krit}^- = \Sigma_i\,\Delta\phi_i^-\,(t_{krit}) \tag{9.2}$$

Bei lokalem Erreichen von $\Delta\phi_{krit}$ erfolgt eine lokale Zunahme der Stromdichte bis hin zur lokalen Zerstörung des Halbleiterbauelements. Dies ist im Verlauf der Leckstromdichte $J_{TED}$ zum Zeitpunkt $t = t_{krit}$ entweder durch einen kurzen Anstieg, gefolgt von einem unmittelbaren Rückfall auf den $J_{TED}$-Wert vor dem Anstieg oder einen bleibenden Sprung erkennbar. Im ersten Fall zerstört der Leitungspfad sich thermisch selber. Im zweiten Fall ist die zugeführte elektrische Leistung nicht ausreichend, um den Leitungspfad vollständig zu zerstören. Nach Überschreiten von $t_{krit}$ verbleibt ein Halbleiterbauelement, welches lokal auf einer begrenzten Fläche zerstört ist. Mit fortschreitender Belastung

bei t > $t_{krit}$ folgen immer weitere lokale dielektrische Durchbrüche, was schließlich zur vollständigen Zerstörung des Halbleiterbauelements führt. Der erste lokale Durchbruch stellt somit ein relevantes Maß für die Lebensdauer des Halbleiterbauelements dar.

Mit der physikalischen Beschreibung der Barrierenhöhenänderung (5) über Hopping-Transport der n Defektarten (6) und (7) kann somit aus zeitlichen Verläufen der Leckstromdichte (1) die Ladung $N_{q,i}$, die wahre Aktivierungsenergie $E_{a,0,i}$, die Höhe der maximalen Barrierenänderungen $\delta\phi_i$ und die charakteristische Zeitkonstante $\tau_i$ ermittelt werden. Wird diese Messung vor und nach einer Variation im Herstellungsprozess durchgeführt, können Halbleiterbauelemente gezielt verbessert werden.

Hierfür werden zunächst an einem Halbleiterbauelement die Leckstromverläufe $J_{TED}$ bis zum dielektrischen Durchbruch zum Zeitpunkt $t_{krit}$ bei mindestens zwei Hauptbetriebsspannungen $U_1$ und $U_2$ und mindestens zwei Hauptbetriebstemperaturen $T_1$ und $T_2$ gemessen. Daraufhin werden die oben beschriebenen Gleichungen (2.2) und (5) gleichgesetzt und aus einem numerischen Fit resultiert folgend aus dem zeitlichen Verlauf von $J_{TED}$ der zeitliche Verlauf der Barrierenhöhenänderung $\Delta\phi$, die Einzelgrößen $\delta\phi_i$ und $\tau_i$. Mit (9.1) bzw. (9.2) erhält man auch die kritische Barrierenabsenkung $\Delta\phi_{krit}$ in Abhängigkeit der Hauptbetriebsspannung und Hauptbetriebstemperatur.

Entsprechend der oben beschriebenen Formeln (6), (7) und (8) folgt $\tau_i$ in Abhängigkeit des elektrischen Feldes E und der Hauptbetriebstemperatur

$$\tau_i(E;T) = \frac{d_i}{C_{0,i}(a_0)\,e^{-\frac{E_{A,0,i}}{k_B T}}}\,\frac{1}{\sinh\left(\frac{N_{q,i}\,a_0}{k_B T}E\right)} = \widetilde{K}_i(a_0)\,\frac{1}{\sinh\left(\frac{N_{q,i}\,a_0}{k_B T}E\right)}\quad (10.1)$$

Aus den so ermittelten $\tau_i$ bei mindestens zwei Hauptbetriebstemperaturen $T_1$ und $T_2$ sowie mindestens zwei Hauptbetriebsspannung $U_1=E_1/d$ und $U_2=E_2/d$ können bei der Anwesenheit von n > 1 Defekten durch mathematischem Fit die Größen $N_{q,i}$, $E_{a,0,i}$, sowie die Größe $a_0$ aus den Gleichungen (10.1) bestimmt werden. Die gemessenen $J_{TED}$ Verläufe unterliegen Fertigungsschwankungen und Toleranzen, welche durch die verwendete Messtechnik bedingt sind. Die Genauigkeit der aus diesen Messungen bestimmten Materialeigenschaften $a_0$, $C_{0,i}(a_0)$, $N_{q,i}$ und $E_{A,0,i}$ kann daher durch Erhöhung von Probenzahl und auch zusätzliche Messdaten bei mehr als zwei Spannungen und/oder mehr als zwei Temperaturen verbessert werden. Nach Änderung der Prozessbedingungen wird die Bestimmung von $\delta\phi_i$ und $\tau_i$ wiederholt und dabei über die Größen $N_{q,i}$ und $E_{a,0,i}$ eindeutig einer Defektart zugeordnet. Hierdurch wird der physikalische Einfluss der Prozessänderung auf die beteiligten i Defekte gezeigt.

Vorzugsweise liegt wenigstens eine weitere dritte Defektart in der dielektrischen Schicht vor. Die dritte Defektart ist hierbei dazu ausgebildet, sich in Abhängigkeit der zwischen der ersten und zweiten Elektrode angelegten Hauptbetriebsspannung und der vorliegenden Hauptbetriebstemperatur in einer charakteristischen Zeit $\tau_3$ an einer der beiden Elektroden anzusammeln und an den Elektroden eine maximale Barrierenhöhenänderung $\delta\Phi_3$ zu erzeugt. Hierbei gilt $\tau_1 < \tau_3 < \tau_3$ wobei die Reihenfolge der maximalen Barrierenhöhenänderungen von der Reihenfolge $\delta\Phi_1 > \delta\Phi_2 > \delta\Phi_3$ abweicht. Das bedeutet, dass beispielsweise $\delta\Phi_3 > \delta\Phi_2 > \delta\Phi_1$ oder $\delta\Phi_2 > \delta\Phi_1 > \delta\Phi_3$ gilt. Es kommen häufiger dielektrische Schichten vor, in denen mehr als nur zwei unterschiedliche Defektarten vorliegen. Im Falle einer PZT-Schicht kommt es beispielsweise vor, dass zumindest lokale Überschüsse oder Defizite der Atome Pb, Ti und Zr in der dielektrischen Schicht vorliegen. Weiterhin kommen in der Praxis Betriebszustände vor, in welchen mehr als zwei Defektarten einen relevanten Beitrag zum elektrischen Versagen der dielektrischen Schicht liefern.

Bevorzugt ist die dielektrische Schicht als ein polykristallines oxidisches high-k Dielektrikum und insbesondere als PZT-Schicht (PZT = Pb[$Zr_x Ti_{1-x}$]$O_3$), dotierte PZT-Schicht (Pb($Zr_x Ti_{1-x-y}$)$O_3 Ni_y$,KNN-Schicht (KNN = [$K_x Na_{1-x}$]$NbO_3$), $HfO_2$, $ZrO_2$ oder $SrTiO_3$ ausgebildet.

Vorzugsweise ist die dielektrische Schicht als gesputterte PZT-Schicht ausgebildet. Hierbei wird das sogenannte Target-Material in einem Plasma auf einem Substrat abgeschieden. Als Target-Material wird beispielsweise PZT verwendet. Bevorzugt wird die gesputterte PZT-Schicht in diesem Zusammenhang bei einer Abscheidetemperatur von kleiner als 500°C abgeschieden. Bei einer solchen dielektrischen Schicht kommt es nachweislich zu dem Effekt, dass abhängig von der gewählten Hauptbetriebspannung und Hauptbetriebstemperatur mehr als zwei Defektarten aktiv zum dielektrischen Versagen beitragen.

Bevorzugt weist die gesputterte PZT-Schicht eine Zusammensetzung von $Pb_x(Zr_{0.52}Ti_{0.48})O_3$ auf. Hierbei gilt für x: $1{,}2 \le x \le 1{,}3$, sodass die Zusammensetzung beispielsweise aus $Pb_{1,2}(Zr_{0.52}Ti_{0.48})O_3$ oder $Pb_{1,3}(Zr_{0.52}Ti_{0.48})O_3$ zusammengesetzt sein kann. Alternativ weist die gesputterte PZT Schicht des Halbleiterbauelements einen Nickelgehalt zwischen 0,1 und 1 Atomprozent auf. Bevorzugt können weiterhin zusätzliche Defekte über Dotierungen in die high-k Dielektrika eingebracht werden, um maximale Barrierenhöhenänderungen $\delta\Phi$ und Zeitkonstanten $\tau$ zu beeinflussen

Beschreibung der Zeichnungen

Figur 1a zeigt den Verlauf einer Leckstrommessung bei fünf unterschiedlichen dielektrischen Schichten.

Figur 1b zeigt den aus einer Leckstrommessung resultierenden zeitlichen Verlauf der effektiven Barrierenhöhe und die Aufgliederung in die Beiträge der vorliegenden Defektarten.

Figur 2a zeigt die maximalen Barrierenhöhenänderungen und charakteristischen Zeitkonstanten von drei Ausführungsbeispielen für den beispielhaften Betriebszustand 175°C/-2,5V.

Figur 2b zeigt die maximalen Barrierenhöhenänderungen und charakteristischen Zeitkonstanten für ein Ausführungsbeispiel bei zwei beispielhaften Betriebszuständen 175°C/-2,5V und 100°C/-10V.

Figur 2c zeigt die maximalen Barrierenhöhenänderungen und charakteristischen Zeitkonstanten von zwei Ausführungsbeispielen für den beispielhaften Betriebszustand 175°C/-2,5V.

Figur 2d zeigt die maximalen Barrierenhöhenänderungen und charakteristischen Zeitkonstanten von zwei Ausführungsbeispielen für den beispielhaften Betriebszustand 175°C/-2,5V.

Figur 2e zeigt die maximalen Barrierenhöhenänderungen und charakteristischen Zeitkonstanten von zwei Ausführungsbeispielen für den beispielhaften Betriebszustand 100°C/-10V.

Figur 3a bis 3d zeigt schematisch die Bewegung unterschiedlicher Defektarten in einer dielektrischen Schicht entlang lokalisierter Defektzustände mit jeweils einem mittleren effektiven Abstand $a_0$.

Ausführungsbeispiele der Erfindung

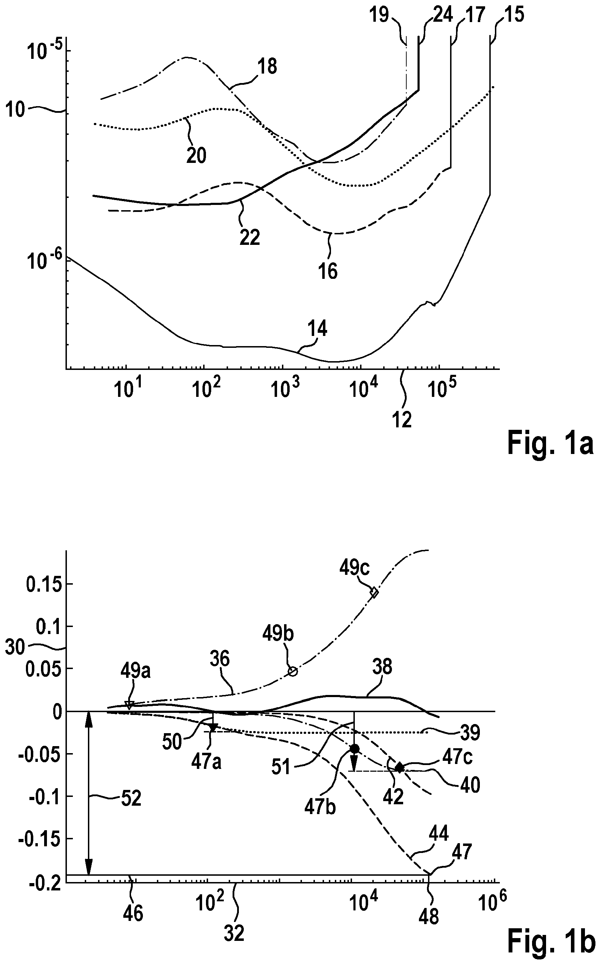

Figur 1a zeigt den Verlauf 14 einer Leckstrommessung einer dielektrischen Schicht eines Halbleiterbauelements, welches im Folgenden als Ausführungsbeispiel 1 bezeichnet wird. Auf der X-Achse 12 ist hierbei die Zeit logarithmisch mit der Einheit Sekunden und auf der Y-Achse 10 die Leckstromdichte in der Einheit Ampere pro Quadratzentimeter logarithmisch aufgetragen. Das für die Leckstrommessung vorgesehene Ausführungsbeispiel 1 wies ein Siliziumsubstrat mit dielektrischen Passivierungsschichten und einer darauf abgeschiedenen ersten Elektrode auf. Diese erste Elektrode wies eine Doppelschicht aus 110nm dickem PVD Platin auf, welche durch eine leitfähige 100nm Lanthan-Nickel-Oxid Pufferschicht (im Folgenden als LNO Schicht bezeichnet) abgedeckt wird. Diese LNO Schicht wurde ebenfalls per PVD aufgebracht. Die auf der ersten Elektrode befindliche dielektrische Schicht wies eine Dicke von 1 $\mu$m auf und wurde in einem RF-PVD Prozess bei einer Temperatur von 480°C und einer Targetzusammensetzung von $Pb_{1.3}(Zr_{0.52}Ti_{0.48})O_3$ abgeschieden. Die restlichen Prozessparameter der zuvor beschriebenen Abscheidungen wurden so gewählt, dass die dielektrische Schicht polykristallin und bevorzugt mit einer (100) c-Achsenorientierung aufwächst. Die zweite Elektrode des Halbleiterelements, eine 110nm dicke Platinelektrode, wurde per PVD auf die dielektrische Schicht aufgebracht. Das Halbleiterbauelement entsprechend Ausführungsbeispiel 1 hat nach der Passivierung und der elektrischen Kontaktierung keine thermische Nachbehandlung erfahren.

Außerdem zeigt Figur 1a den Verlauf 16 einer Leckstrommessung einer dielektrischen Schicht eines weiteren Halbleiterbauelements, welches im Folgenden als Ausführungsbeispiel 2 bezeichnet wird. Die Herstellung von Ausführungsbeispiel 2 erfolgte analog zu Ausführungsbeispiel 1, jedoch wurden die Bauelemente nach elektrischer Kontaktierung einer thermischen Nachbehandlung unterzogen. Diese erfolgte bei 450°C für 40 Minuten in 60 mbar Stickstoffatmosphäre.

Zudem zeigt Figur 1a den Verlauf 18 einer Leckstrommessung einer dielektrischen Schicht eines weiteren Halbleiterbauelements, welches im Folgenden als Ausführungsbeispiel 3 bezeichnet wird. Die Herstellung von Ausführungsbeispiel 3 erfolgte analog zu Ausführungsbeispiel 1, jedoch wurden die Bauelemente nach elektrischer Kontaktierung einer thermischen Nachbehandlung unterzogen. Diese erfolgte bei 500°C für 40 Minuten in 60 mbar Stickstoffatmosphäre.

Zudem zeigt Figur 1a den Verlauf 20 einer Leckstrommessung einer dielektrischen Schicht eines weiteren Halbleiterbauelements, welches im Folgenden als Ausführungsbeispiel 4 bezeichnet wird. Die Herstellung von Ausführungsbeispiel 4 erfolgte analog zu Ausführungsbeispiel 1, jedoch wurde die dielektrische Schicht mit einer Target-Zusammensetzung von $Pb_{1.2}(Zr_{0.52}Ti_{0.48})O_3$ abgeschieden.

Außerdem zeigt Figur 1a den Verlauf 22 einer Leckstrommessung einer dielektrischen Schicht eines weiteren Halbleiterbauelements, welches im Folgenden als Ausführungsbeispiel 5 bezeichnet wird. Die Herstellung von Ausführungsbeispiel 5 erfolgte analog zu Ausführungsbeispiel 1, jedoch wurde die dielektrische Schicht mit einer Target-Zusammensetzung von $Pb_{1.3}(Zr_{0.52}Ti_{0.48})O_3Ni_{0.005}$ abgeschieden.

Vor der Messung der Leckstromverläufe wurden alle beschriebenen Ausführungsbeispiele 1, 2, 3, 4 und 5 mit Passivierungsschichten abgedeckt und mit Aluminiumleiterbahnen elektrisch kontaktiert.

Vier der fünf Ausführungsbeispiele wurden bis zum jeweiligen dielektrischen Durchbruch 15, 17, 19 und 24 gemessen. Wie hierbei zu erkennen ist, ergeben sich abhängig von der Herstellung und der Zusammensetzung einer dielektrischen Schicht sehr unterschiedliche Leckstromverläufe 14, 16, 18, 20 und 22 mit unterschiedlichen Durchbruchszeiten 17, 15, 19 und 24.

Figur 1b zeigt beispielhaft das Extrahieren von Modellgrößen anhand des auf Figur 1a gemessenen Leckstromverlaufs 16 an Ausführungsbeispiel 2. Auf der X-Achse 32 ist hierbei wiederum die Zeit logarithmisch mit der Einheit Sekunden und auf der Y-Achse 30 die Barrierenhöhenänderung $\Delta\phi$ mit der Einheit Elektronenvolt logarithmisch aufgetragen. Der Verlauf 38 zeigt hierbei den in Abhängigkeit von der Zeit ermittelten Verlauf der Barrierenhöhenänderung $\Delta\phi(t)$ ausgehend von einer Ausgangsbarrierenhöhe $\phi_0$.

Dieser Verlauf 38 der Barrierenhöhenänderung $\Delta\phi(t)$ wird ermittelt durch die Formel (siehe obige Formel 2.2):

$$\Phi(t) = [\ln(K) - \ln(J_{TED}(t))]k_B T$$

Darauf folgend wird der ermittelte zeitliche Verlauf der mittleren effektiven Barrierenhöhe $\phi(t)$ numerisch auf die Formel (siehe obige Formel 3.2) angepasst:

$$\phi(t) = \phi_0 + \sum_i \Delta\phi_i^+(t) + \sum_i \Delta\phi_i^-(t)$$

Man erhält aus diesem numerischen Fit entsprechend unterschiedliche $\Delta\phi_i^{+/-}(t)$, die den Verlauf von $\Delta\phi(t)$ beschreiben. So wird in dem gezeigten Fall $\Delta\phi(t)$ 38 durch den Verlauf von $\Delta\phi_a^-(t)$ 39, den Verlauf von $\Delta\phi_b^-(t)$ 40 und den Verlauf von $\Delta\phi_c^-(t)$ 42 zusammen mit dem Summenverlauf $\sum_i\Delta\phi_i^+$ 36 beschrieben. Entsprechend der folgenden Formel (siehe obige Formel 5.1)

$$\Delta\phi(t) = \sum_i \delta\phi_i^{+/-}\left(1 - e^{\frac{t}{\tau_i^{+/-}}}\right)$$

können dann die unterschiedlichen $\tau_i^{+/-}$ und $\delta\phi_i^{+/-}$ ermittelt werden. Man erhält in diesem Fall für die den Majoritätsladungsträgern zugeordneten Barrierenhöhenänderungen $\Delta\phi_i^-$ 39, 40 und 42 eine zugehörige charakteristische Zeitkonstante $\tau_a$, $\tau_b$ und $\tau_c$. Diese sind in Figur 1b jeweils gekennzeichnet durch 47a, 47b und 47c und stellen den Zeitpunkt dar, zu welchem sich die entsprechende Barrierenhöhenänderung am stärksten verändert. Die zugehörigen maximalen Barrierenabsenkungen $\delta\phi_i^-$ für die Verläufe $\Delta\phi_i^-$ 39, 40 sind beispielhaft mit 50 und 51 gekennzeichnet. Die Barrierenhöhenänderungen $\Delta\phi_i^+$ für die Minoritätsladungsträger wurden zur Verbesserung der Übersicht nicht explizit einzeln dargestellt. Gezeigt ist lediglich deren Summenverlauf $\sum_i\Delta\phi_i^+$ 36 mit den einzelnen Zeitkonstanten $\tau_d$, $\tau_e$ und $\tau_f$ 49a, 49b und 49c. Eine jeweilige charakteristische Zeitkonstante ist hierbei einer in der Schicht vorliegenden Defektart a, b, c, d, e und f zugeordnet. Somit liegen entsprechend in dieser dielektrischen Schicht sechs zueinander unterschiedliche Defektarten vor.

In dem auf Figur 1b dargestellten Fall erfolgt der dielektrische Durchbruch 47 der dielektrischen Schicht durch tunnelnde Majoritätsladungsträger entsprechend der folgenden Formel (siehe obige Formel 9.2):

$$\phi_{krit}^- = \phi_0^- + \Sigma_i\,\Delta\phi_i^-\,(t_{krit}) = \phi_0^- + \Delta\phi_{krit}^- \qquad mit\ \Delta\phi_{krit}^- = \Sigma_i\,\Delta\phi_i^-\,(t_{krit})$$

Die zuvor ermittelten Verläufe von $\Delta\phi_a^-(t)$ 39, $\Delta\phi_b^-(t)$ 40 und $\Delta\phi_c^-(t)$ 42 werden also aufsummiert und führen entsprechend ihres Verlaufs zu Barrierenhöhenänderungen $\Sigma_i\Delta\phi_i^-$ 44. Wird hierbei zu dem Zeitpunkt $t_{krit}$ 48 die für die Majoritätsladungsträger kritische Barrierenhöhenänderung $\Delta\phi_{krit}^-$ 52 der dielektrischen Schicht erreicht, kommt es infolge der unterschiedlichen vorliegenden Defektarten a, b und c, welche sich an einer Grenzschicht zwischen dielektrischer Schicht und Elektrode angelagert haben, zu einem lokalen Durchbruch der Schicht.

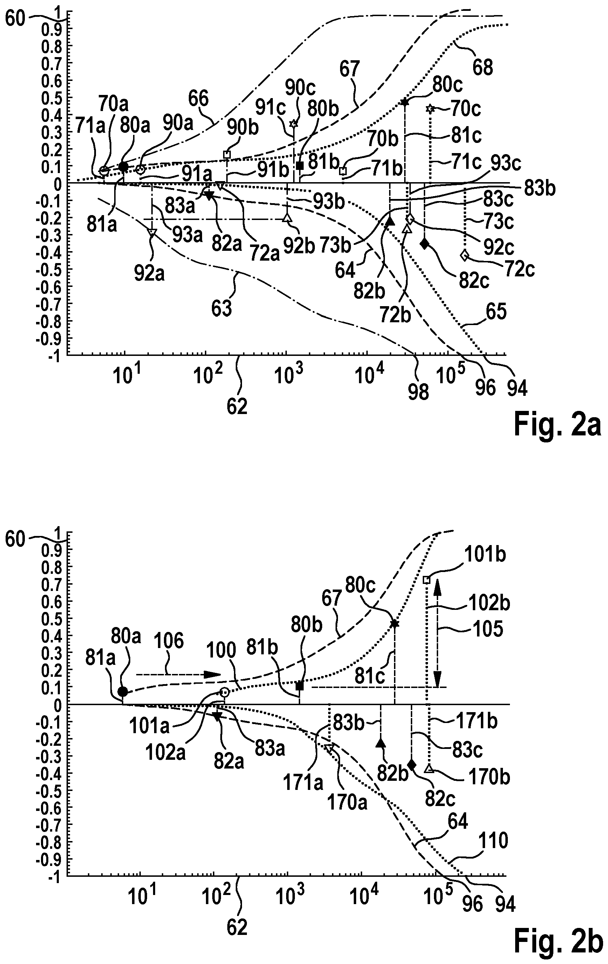

Figur 2a zeigt die gemessenen Verläufe der Barrierenhöhenänderungen $\Delta\phi(t)^\pm$ für die drei Ausführungsbei-

spiele 1, 2 und 3 mit den jeweiligen charakteristischen Zeitkonstanten $\tau_i^{+/-}$ und maximalen Barrierenhöhenänderungen $\delta\phi_i^{+/-}$ bei einer Hauptbetriebstemperatur von 175°C und einer Hauptbetriebsspannung von -2,5V. Auf der X-Achse 62 ist hierbei die Zeit logarithmisch mit der Einheit Sekunden und auf der Y-Achse 60 die Barrierenhöhenänderung geteilt durch die kritische Barrierenhöhenänderung $\Delta\phi_{krit}^-$ des jeweiligen Ausführungsbeispiels 1,2 und 3 einheitenlos aufgetragen.

Hierbei sind die Verläufe von $\Delta\phi(t)^-$ 63, 64, 65 für die Ausführungsbeispiele 3, 2 und 1, sowie die zugehörigen Verläufe von $\Delta\phi(t)^+$ 66, 67, 68 der Ausführungsbeispiele 3, 2 und 1 dargestellt. Das elektrische Versagen der dielektrischen Schichten der Ausführungsbeispiele erfolgt jeweils zu den zugehörigen Zeitpunkten 94, 96 und 98, zu denen die kritische Barrierenhöhenabsenkung erreicht ist.

Das Defektgefüge für Ausführungsbeispiel 1 setzt sich hierbei aus den Defektarten a, b, c, d, e, und f mit ihren zugeordneten Zeitkonstanten $\tau_a$ 72a, $\tau_b$ 72b, $\tau_c$ 72c, $\tau_d$ 90a, $\tau_e$ 70b und $\tau_f$ 70c zusammen. Den unterschiedlichen Defektarten sind die verursachten maximalen Barrierenhöhenabsenkungen $\delta\phi_b^-$ 72c, $\delta\phi_c^-$ 73c, $\delta\phi_d^+$ 91a, $\delta\phi_e^+$ 71b und $\delta\phi_f^+$ 71c zugeordnet.

Das Defektgefüge für Ausführungsbeispiel 2 setzt sich hierbei aus den Defektarten a, b, c, d, e, und f mit ihren zugeordneten Zeitkonstanten $\tau_a$ 82a, $\tau_b$ 82b, $\tau_c$ 82c, $\tau_d$ 80a, $\tau_e$ 80b und $\tau_f$ 80c zusammen. Den unterschiedlichen Defektarten sind auch hierbei die verursachten maximalen Barrierenhöhenabsenkungen $\delta\phi_a^-$ 83a, $\delta\phi_b^-$ 83b, $\delta\phi_c^-$ 83c, $\delta\phi_d^+$ 81a, $\delta\phi_e^+$ 81b und $\delta\phi_f^+$ 81c zugeordnet.

Das Defektgefüge für Ausführungsbeispiel 3 setzt sich hierbei aus den Defektarten a, b, c, d, e, und f mit ihren zugeordneten Zeitkonstanten $\tau_a$ 92a, $\tau_b$ 92b, $\tau_c$ 92c, $\tau_d$ 70a, $\tau_e$ 90b und $\tau_f$ 90c zusammen. Den unterschiedlichen Defektarten sind wiederum die verursachten maximalen Barrierenhöhenabsenkungen $\delta\phi_a^-$ 93a, $\delta\phi_b^-$ 93b, $\delta\phi_c^-$ 93c, $\delta\phi_d^+$ 71a, $\delta\phi_e^+$ 91b und $\delta\phi_f^+$ 91c zugeordnet.

Für die unterschiedlichen Defektarten können durch den mathematischen Fit an das oben beschriebene Modell und der folgenden Gleichung (siehe obige Gleichung 10.1)

$$\tau_i(E;T) = \frac{d_i}{C_{0,i}(a_0)\ e^{-\frac{E_{A,0,i}}{k_BT}}}\ \frac{1}{\sinh\left(\frac{N_{q,i}\,a_0}{k_BT}E\right)}$$

wahre Aktivierungsenergien $E_{A,0,i}$ und Ladungen $N_{q,i}$ ermittelt werden. Für die Defektart a ergibt sich eine wahre Aktivierungsenergie von 0,92 eV bei einer Ladung von 1e. Für die Defektart b ergibt sich eine wahre Aktivierungsenergie von 0,95 eV bei einer Ladung von 3e. Für die Defektart c ergibt sich eine wahre Aktivierungsenergie von 0,855 eV bei einer Ladung von 4e. Für die Defektart d ergibt sich eine wahre Aktivierungsenergie von <0,8 eV bei einer Ladung von 1e. Für die Defektart e ergibt sich eine wahre Aktivierungsenergie von 1,04 eV bei einer Ladung von 2e. Für die Defektart f ergibt sich eine wahre Aktivierungsenergie von 1,22 eV bei einer Ladung von 2e. Damit kann Defektart a beispielsweise physikalisch mit Wasserstoff und/oder OH-Gruppen und Defektart e mit Sauerstofffehlstellen und/oder Blei im Inneren der dielektrischen Schicht in Verbindung gebracht werden. Durch die unterschiedlichen Herstellungen der Ausführungsbeispiele 1, 2 und 3 werden die maximalen Barrierenhöhenabsenkungen der Defektarten a und e $\delta\phi_a^-$ bzw. $\delta\phi_e^+$ geändert. Bei den hierbei gewählten beispielhaften Hauptbetriebsbedingungen gilt für die Ausführungsbeispiele 1 und 2 des Halbleiterbauelements: $\tau_a < \tau_b$ und $\delta\phi_a^- < \delta\phi_b^-$. Durch die zu einem relativ frühen Zeitpunkt 92a erfolgende relativ große Barrierenabsenkung 93a von Ausführungsbeispiel 3 wird der Barrierenverlauf 63 von Ausführungsbeispiel 3 beeinflusst. Dies führt zu einem im Vergleich zu den Ausfallzeitpunkten $t_{krit}$ 94 bzw. 96 der Ausführungsbeispielen 1 bzw. 2 zeitlich früheren elektrischen Versagen zu dem Zeitpunkt $t_{krit}$ 98. Um eine längere Lebensdauer des Halbleiterbauelements zu erreichen, sollten entsprechend zeitlich früh stattfindende Barrierenabsenkungen klein sein. Für die Ausführungsbeispiele 1 und 2 wird weiterhin gezeigt, dass gilt $\tau_a < \tau_b < \tau_c$ und $\delta\phi_a^- < \delta\phi_b^- < \delta\phi_c^-$.

Figur 2b zeigt einen Vergleich der Verläufe der Barrierenhöhenänderungen $\Delta\phi(t)^{\pm}$ für das Ausführungsbeispiel 2 bei zwei unterschiedlichen Betriebsbedingungen mit den jeweiligen charakteristischen Zeitkonstanten $\tau_i^{+/-}$ und maximalen Barrierenhöhenänderungen $\delta\phi_i^{+/-}$. Auf der X-Achse 62 ist hierbei die Zeit logarithmisch mit der Einheit Sekunden und auf der Y-Achse 60 die Barrierenhöhenänderung geteilt durch die kritische Barrierenhöhenänderung $\Delta\phi_{krit}^-$ des jeweiligen Betriebszustands einheitenlos aufgetragen.

Hierbei ergibt sich der Verlauf $\Delta\phi(t)^-$ 64 für die Hauptbetriebstemperatur 175°C und einer Hauptbetriebsspannung von -2,5V (im Folgenden mit Betriebsbedingung a bezeichnet), sowie der Verlauf $\Delta\phi(t)^-$ 110 für die Hauptbetriebstemperatur 100°C und einer Hauptbetriebsspannung von -10V (im Folgenden mit Betriebsbedingung b bezeichnet). Der zugehörige Verlauf $\Delta\phi(t)^+$ 67 für die Betriebsbedingung a und der Verlauf $\Delta\phi(t)^+$ 100 für die Betriebsbedingung b sind ebenfalls dargestellt.

Das elektrische Versagen der dielektrischen Schicht erfolgt für die Betriebsbedingungen a und b jeweils zu den Zeitpunkten 96 und 97. Das Defektgefüge für Ausführungsbeispiel 2 bei Betriebsbedingung a ist hierbei durch die bis zum elektrischen Versagen aktiven Defektarten a, b, c, d, e, und f mit ihren zugeordneten Zeitkonstanten $\tau_a$ 82a, $\tau_b$ 82b, $\tau_c$ 82c, $\tau_d$ 80a, $\tau_e$ 80b und $\tau_f$ 80c und den durch diese Defektarten verursachten maximalen Barrierenhöhenabsenkungen $\delta\phi_a^-$ 83a, $\delta\phi_b^-$ 83b, $\delta\phi_c^-$ 83c, $\delta\phi_d^+$ 81a, $\delta\phi_e^+$ 81b und $\delta\phi_f^+$ 81c ausgebildet.

Das Defektgefüge für Ausführungsbeispiel 2 bei Betriebsbedingung b ist hierbei durch die bis zum elektrischen Versagen aktiven Defektarten a, b, d und e mit ihren zugeordneten Zeitkonstanten $\tau_a$ 170a, $\tau_b$ 170b, $\tau_d$ 101a und $\tau_e$ 101b und den durch diese Defektarten verursachten maximalen Barrierenhöhenabsenkungen $\delta\phi_a^-$ 171a, $\delta\phi_b^-$ 171b, $\delta\phi_d^+$ 102b und $\delta\phi_e^+$ 102b ausgebildet.

Zu erkennen ist, dass das Defektgefüge und die bis zum elektrischen Durchbruch wirksamen Defekte in einem Halbleiterbauelement von der gewählten Betriebsbedingung abhängen. Zeitliche Verschiebungen 106 werden durch die Hauptbetriebstemperatur und den Term $e^{-\frac{E_{A,0,i}}{k_B T}}$ in Gleichung (10.1) verursacht. Änderungen 105 der maximalen Barrierenhöhenabsenkungen werden durch Änderungen der Hauptbetriebsspannung und damit einhergehende Änderungen von $\Delta\phi_{krit}^{\pm}$ verursacht.

Für das Ausführungsbeispiel 2 gilt für Betriebsbedingungen a: $\tau_a < \tau_b < \tau_c$ und $\delta\phi_a^- < \delta\phi_b^- < \delta\phi_c^-$, sowie $\tau_d < \tau_e < \tau_f$ und $\delta\phi_d^+ < \delta\phi_e^+ < \delta\phi_f^+$. Darüber hinaus gilt für das Ausführungsbeispiel 2 für Betriebsbedingungen b: $\tau_a < \tau_b$ und $\delta\phi_a^- < \delta\phi_b^-$, sowie $\tau_d < \tau_e$ und $\delta\phi_d^+ < \delta\phi_e^+$.

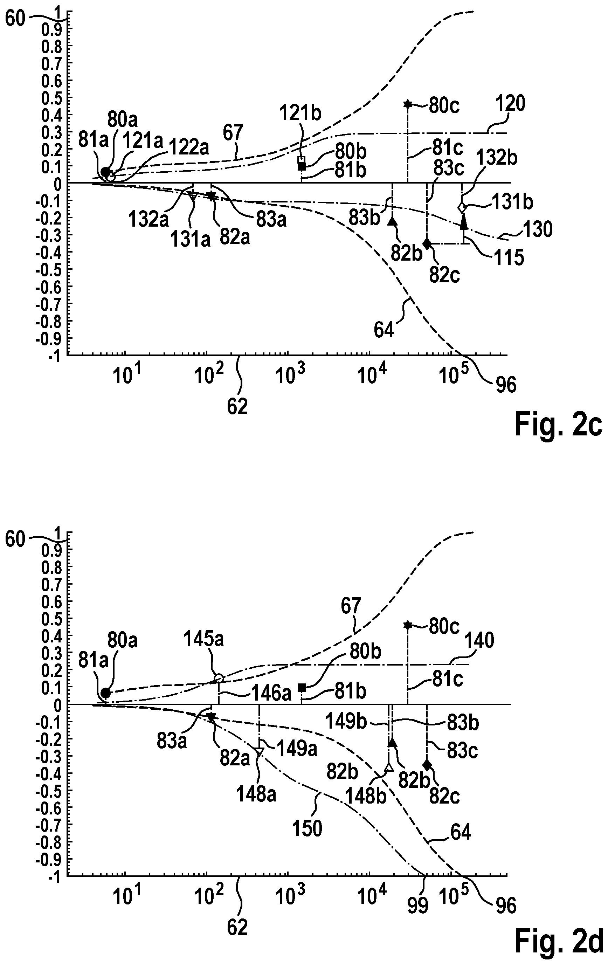

Figur 2c zeigt einen Vergleich der Verläufe der Barrierenhöhenänderungen $\Delta\phi(t)^{\pm}$ für die zwei Ausführungsbeispiele 2 und 4 mit ihren jeweiligen charakteristischen Zeitkonstanten $\tau_i^{+/-}$ und maximalen Barrierenhöhenänderungen $\delta\phi_i^{+/-}$ bei einer Hauptbetriebstemperatur von 175°C und einer Hauptbetriebsspannung von -2,5V. Auf der X-Achse 62 ist hierbei die Zeit logarithmisch mit der Einheit Sekunden und auf der Y-Achse 60 die Barrierenhöhenänderung geteilt durch die kritische Barrierenhöhenänderung $\Delta\phi_{krit}^-$ von Ausführungsbeispiel 2 einheitenlos aufgetragen. Die Barrierenhöhenänderung von Ausführungsbeispiel 4 wurde derart normiert, dass die maximalen Barrierenhöhenänderungen $\delta\phi_a^-$ 132a und $\delta\phi_a^-$ 83a identisch sind.

Dargestellt ist hierbei der Verlauf $\Delta\phi(t)^-$ 64 von Ausführungsbeispiel 2, sowie der Verlauf $\Delta\phi(t)^-$ 130 von Ausführungsbeispiel 4. Außerdem ist der Verlauf $\Delta\phi(t)^+$ 67 von Ausführungsbeispiel 2, sowie der Verlauf $\Delta\phi(t)^+$ 120 von

Ausführungsbeispiel 4 dargestellt. Das elektrische Versagen der dielektrischen Schicht von Ausführungsbeispiel 2 erfolgt zum Zeitpunkt 96, wenn die kritische Barrierenhöhenabsenkung erreicht ist. Ausführungsbeispiel 4 konnte im Versuchszeitraum nicht bis zum Versagen belastet werden und Verlauf 130 erreicht den Wert -1 daher nicht.

Das Defektgefüge für Ausführungsbeispiel 2 ist hierbei durch die Defektarten a, c, d, e, und f mit ihren zugeordneten Zeitkonstanten $\tau_a$ 82a, $\tau_b$ 82b, $\tau_c$, 82c, $\tau_d$ 80a, $\tau_e$ 80b und $\tau_f$ 80c und den durch diese Defektarten verursachten maximalen Barrierenhöhenabsenkungen $\delta\phi_a^-$ 83a, $\delta\phi_b^-$ 83b, $\delta\phi_c^-$ 83c, $\delta\phi_d^+$ 81a, $\delta\phi_e^+$ 81b und $\delta\phi_f^+$ 81c ausgebildet.

Das Defektgefüge für Ausführungsbeispiel 4 ist hierbei durch die Defektarten a, c, d und e mit ihren zugeordneten Zeitkonstanten $\tau_a$ 131a, $\tau_c$ 131b, $\tau_d$ 121a und $\tau_e$ 121b und den durch diese Defektarten verursachten maximalen Barrierenhöhenabsenkungen $\delta\phi_a^-$ 132a, $\delta\phi_c^-$ 132b und $\delta\phi_d^+$ 122a ausgebildet.

Für die Defektart a ergibt sich eine wahre Aktivierungsenergie von 0,92 eV bei einer Ladung von 1e. Für die Defektart b ergibt sich eine wahre Aktivierungsenergie von 0,95 eV bei einer Ladung von 3e. Für die Defektart c ergibt sich eine wahre Aktivierungsenergie von 0,855 eV bei einer Ladung von 4e. Für die Defektart d ergibt sich eine wahre Aktivierungsenergie von <0,8 eV bei einer Ladung von 1e. Für die Defektart e ergibt sich eine wahre Aktivierungsenergie von 1,04 eV bei einer Ladung von 2e. Für die Defektart f ergibt sich eine wahre Aktivierungsenergie von 1,22 eV bei einer Ladung von 2e. Aufgrund einer Reduktion des Bleigehalts in der gesputterten PZT-Schicht von Ausführungsbeispiel 4 konnten die maximalen Barrierenhöhenabsenkungen $\delta\phi_b^-$, $\delta\phi_c^-$ und $\delta\phi_f^+$ der mit Blei in Zusammenhang stehenden Defektarten b, c und f im Vergleich zu Ausführungsbeispiel 2 reduziert werden. Diese Reduktion ist mit 115 beispielhaft für $\delta\phi_c^-$ 132 b gekennzeichnet. Die maximalen Barrierenhöhenabsenkungen $\delta\phi_b^-$ und $\delta\phi_f^+$ sind so klein, dass sie durch den numerischen Fit an das Modell nicht mehr erkennbar vorhanden sind. Da für Defektart b gilt $\tau_a < \tau_b < \tau_c$ kann abgeleitet werden, dass gilt $\tau_b < \tau_c$ und $\delta\phi_b^- \ll \delta\phi_c^-$.

Figur 2d zeigt einen Vergleich der Verläufe der Barrierenhöhenänderungen $\Delta\phi(t)^{\pm}$ für die zwei Ausführungsbeispiele 2 und 5 mit ihren jeweiligen charakteristischen Zeitkonstanten $\tau_i^{+/-}$ und maximalen Barrierenhöhenänderungen $\delta\phi_i^{+/-}$ bei einer Hauptbetriebstemperatur von 175°C und einer Hauptbetriebsspannung von -2,5V. Auf der X-Achse 62 ist hierbei die Zeit logarithmisch mit der Einheit Sekunden und auf der Y-Achse 60 die Barrierenhöhenänderung geteilt durch die kritische Barrierenhöhenänderung $\Delta\phi_{krit}^-$ des jeweiligen Ausführungsbeispiels 2 und 5 einheitenlos aufgetragen.

Hierbei ist der Verlauf $\Delta\phi(t)^-$ 64 von Ausführungsbeispiel 2, sowie der Verlauf $\Delta\phi(t)^-$ 150 von Ausführungsbeispiel 5 dargestellt. Außerdem ist der zugehörige Verlauf $\Delta\phi(t)^+$ 67 von Ausführungsbeispiel 2, sowie der Verlauf $\Delta\phi(t)^+$ 140 von Ausführungsbeispiel 5 dargestellt. Das elektrische Versagen der dielektrischen Schicht von Ausführungsbeispiel 2 erfolgt zum Zeitpunkt 96 und bei Ausführungsbeispiel 5 zum Zeitpunkt 99.

Das Defektgefüge für Ausführungsbeispiel 2 ist hierbei durch die Defektarten a, b, c, d, e, und f mit ihren zugeordneten Zeitkonstanten $\tau_a$ 82a, $\tau_b$ 82b, $\tau_c$ 82c, $\tau_d$ 80a, $\tau_e$ 80b und $\tau_f$ 80c und den durch diese Defektarten verursachten maximalen Barrierenhöhenabsenkungen $\delta\phi_a^-$ 83a, $\delta\phi_b^-$ 83b, $\delta\phi_c^-$ 83c, $\delta\phi_d^+$ 81a, $\delta\phi_e^+$ 81b und $\delta\phi_f^+$ 81c ausgebildet.

Das Defektgefüge für Ausführungsbeispiel 5 ist hierbei durch die Defektarten a, b und d mit ihren zugeordneten Zeitkonstanten $\tau_a$ 148a, $\tau_b$ 148b und $\tau_d$ 145a und den durch diese Defektarten verursachten maximalen Barrierenhöhenabsenkungen $\delta\phi_a^-$ 149a, $\delta\phi_b^-$ 149b und $\delta\phi_d^+$ 146a ausgebildet.

Für die Defektart a ergibt sich eine wahre Aktivierungsenergie von 0,92 eV bei einer Ladung von 1e. Für die Defektart b ergibt sich eine wahre Aktivierungsenergie von 0,95 eV bei einer Ladung von 3e. Für die Defektart c ergibt sich eine wahre Aktivierungsenergie von 0,855 eV bei einer Ladung von 4e. Für die Defektart d ergibt sich eine wahre Aktivierungsenergie von <0,8 eV bei einer Ladung von 1e. Für die Defektart e ergibt sich eine wahre Aktivierungsenergie von 1,04 eV bei einer Ladung von 2e. Für die Defektart f ergibt sich eine wahre Aktivierungsenergie von 1,22 eV bei einer Ladung von 2e. Durch den zusätzlichen Nickelgehalt in der gesputterten PZT-Schicht von Ausführungsbeispiel 5 konnten die maximalen Barrierenhöhenabsenkungen $\delta\phi_a^-$ und $\delta\phi_b^-$ deutlich beeinflusst werden. Zudem konnten die maximal Barrierenhöhenabsenkungen $\delta\phi_e^+$ und $\delta\phi_f^+$ soweit reduziert werden, dass sie durch den numerischen Fit an das Modell nicht mehr erkennbar vorhanden sind. Für das Ausführungsbeispiel 5 gilt für die Betriebsbedingungen 175°C und -2,5V: $\tau_a < \tau_b$ und $\delta\phi_a^- < \delta\phi_b^-$.

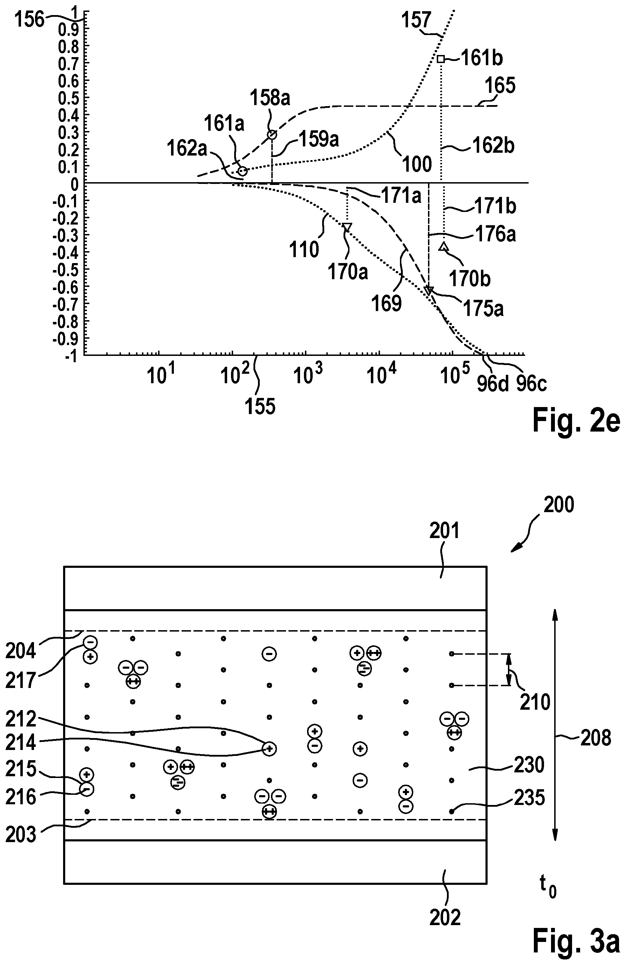

Figur 2e zeigt einen Vergleich der Verläufe der Barrierenhöhenänderungen $\Delta\phi(t)^\pm$ für die zwei Ausführungsbeispiele 2 und 5 bei einer Hauptbetriebstemperatur von 100°C und einer Hauptbetriebsspannung von -10V mit den jeweiligen charakteristischen Zeitkonstanten $\tau_i^{+/-}$ und maximalen Barrierenhöhenänderungen $\delta\phi_i^{+/-}$. Auf der X-Achse 155 ist hierbei die Zeit logarithmisch mit der Einheit Sekunden und auf der Y-Achse 156 die Barrierenhöhenänderung geteilt durch die kritische Barrierenhöhenänderung $\Delta\phi_{krit}^-$ des jeweiligen Ausführungsbeispiels 2 und 5 einheitenlos aufgetragen.

Hierbei ist der Verlauf $\Delta\phi(t)^-$ 110 von Ausführungsbeispiel 2, sowie der Verlauf $\Delta\phi(t)^-$ 169 von Ausführungsbeispiel 5 dargestellt. Zudem ist der zugehörige Verlauf $\Delta\phi(t)^+$ 100 von Ausführungsbeispiel 2, sowie $\Delta\phi(t)^+$ 165 von Ausführungsbeispiel 5 dargestellt. Das elektrische Versagen der dielektrischen Schicht von Ausführungsbeispiel 2 erfolgt zum Zeitpunkt 96c und von Ausführungsbeispiel 5 zum Zeitpunkt 96d.

Das Defektgefüge für Ausführungsbeispiel 2 ist hierbei durch die Defektarten a, b, d und e mit ihren zugeordneten Zeitkonstanten $\tau_a$ 170a, $\tau_b$ 170b, $\tau_d$ 161a und $\tau_e$ 161b und den durch diese Defektarten verursachten maximalen Barrierenhöhenabsenkungen $\delta\phi_a^-$ 171a, $\delta\phi_b^-$ 171b, $\delta\phi_d^+$ 162a und $\delta\phi_e^+$ 162b ausgebildet.

Das Defektgefüge für Ausführungsbeispiel 5 ist hierbei durch die Defektarten a und d mit ihren zugeordneten Zeitkonstanten $\tau_a$ 175a und $\tau_d$ 158a und den durch diese Defektarten verursachten maximalen Barrierenhöhenabsenkungen $\delta\phi_a^-$ 176a und $\delta\phi_d^+$ 159a.

Für die Defektart a ergibt sich eine wahre Aktivierungsenergie von 0,92 eV bei einer Ladung von 1e. Für die Defektart b ergibt sich eine wahre Aktivierungsenergie von 0,95 eV bei einer Ladung von 3e. Für die Defektart d ergibt sich eine wahre Aktivierungsenergie von <0,8 eV bei einer Ladung von 1e. Für die Defektart e ergibt sich eine wahre Aktivierungsenergie von 1,04 eV bei einer Ladung von 2e. Durch den zusätzlichen Nickelgehalt in der gesputterten PZT-Schicht von Ausführungsbeispiel 5 konnte die maximale Barrierenhöhenabsenkung $\delta\phi_a^-$ 176a deutlich beeinflusst werden. Zudem konnte die maximale Barrierenhöhenabsenkung $\delta\phi_e^+$ soweit reduziert werden, dass sie durch den numerischen Fit an das Modell nicht mehr erkennbar vorhanden ist.

Für das Ausführungsbeispiel 2 gilt für Betriebsbedingungen 100°C und -10V: $\tau_a < \tau_b$ und $\delta\phi_a^- < \delta\phi_b^-$, sowie $\tau_d < \tau_e$ und $\delta\phi_d^+ < \delta\phi_e^+$. Figur 3a zeigt schematisch ein Halbleiterbauelement 200 zu einem ersten Zeitpunkt $t_0$. Das Halbleiterbauelement 200 umfasst hierbei eine dielektrische Schicht 230 mit einer Schichtdicke 208. Bei der dielektrischen Schicht 230 kann es sich beispielsweise um eine PZT-Schicht handeln. Zudem weist das Halbleiterbauelement 200 eine erste Elektrode 202 und eine zweite Elektrode 201 auf, die gegenüberliegend zueinander angeordnet sind. Zwischen einer jeweiligen Elektrode 201 oder 202 und der dielektrischen Schicht 230 ist zudem eine Grenzschicht 203 oder 204 angeordnet. In der dielektrischen Schicht 230 liegen unterschiedliche Defektarten vor, welche hier beispielhaft als Defektart 212 mit einfach positiver Ladung 214 und den Defektarten 215 und 217 mit einfach negativer Ladung 216 gekennzeichnet sind. Die Indizes + und - kennzeichnen hierbei jeweils die Anzahl der Ladungsträger einer entsprechenden Defektart. Aufgrund der notwendigen Ladungsneutralität in der dielektrischen Schicht 230 sind Defektpaare beziehungsweise Defektansammlungen vorhanden. Das heißt, bei Auftreten von Defekten mit negativer Ladung 215 und 217 existieren ebenso Defekte mit positiver Ladung 212 im Material. Die unterschiedlichen Defektarten 212, 215 und 217 sind auf lokalisierten Störstellen 235 angeordnet. Zu dem auf Figur 3a dargestellten ersten Zeitpunkt to ist noch keine Spannung zwischen den Elektroden 201 und 202 und somit auch kein elektrisches Feld angelegt.

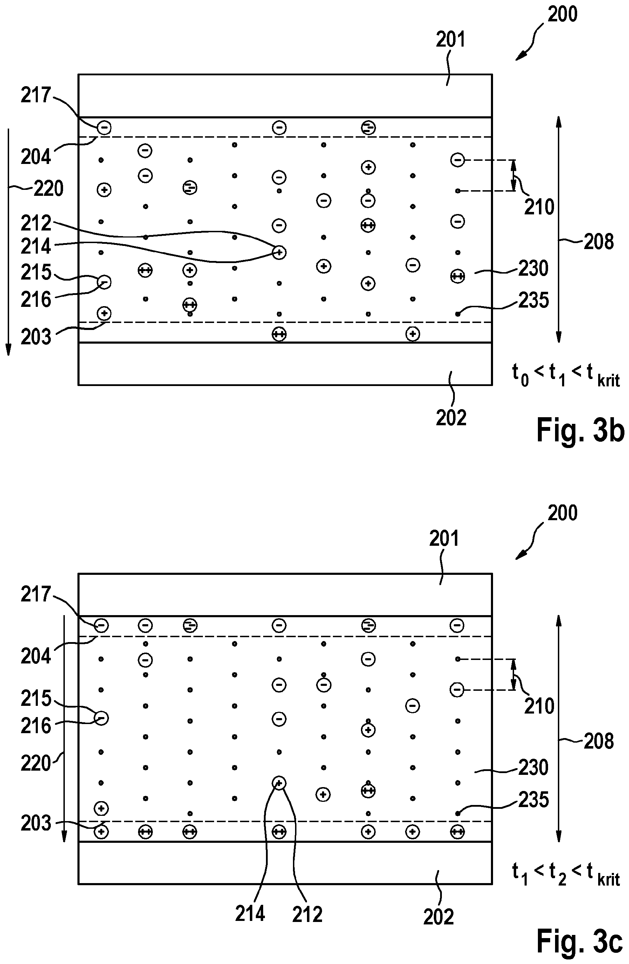

Figur 3b zeigt das Halbleiterbauelement 200 zu einem auf den ersten Zeitpunkt $t_0$ folgenden zweiten Zeitpunkt

$t_1$. Zu diesem Zeitpunkt $t_1$ ist eine Spannung zwischen der ersten Elektrode 202 und der zweiten Elektrode 201 angelegt und somit wird ein elektrisches Feld 220 in der dielektrischen Schicht 230 erzeugt. Die unterschiedlichen Defektarten 212, 215 und 217 bewegen sich nun in Abhängigkeit der zwischen der ersten 201 und zweiten Elektrode 202 angelegten Hauptbetriebsspannung und einer vorliegenden Hauptbetriebstemperatur entlang der lokalisierten Defektzustände 235. Dieser Bewegungszustand der Defektarten 212, 215 und 217 wird auch als Hopping bezeichnet. Jede Defektart bewegt sich in Richtung einer entsprechenden Elektrode mit einer unterschiedlichen Geschwindigkeit. Die jeweilige Zeit, die eine Defektart benötigt, um nach Anlegen der Hauptbetriebsspannung von der Ausgangsposition zu einer jeweiligen, einer Elektrode zugeordneten Grenzschicht zu gelangen, wird als charakteristische Zeit $\tau_i$ bezeichnet. Die lokalisierten Defektzustände 235 weisen jeweils einen gleichen mittleren effektiven Abstand $a_0$ 210 auf. Defektarten 212 mit positiver Ladung 214 wandern zur Elektrode mit negativem Potential (in diesem Fall der ersten Elektrode 202) und lagern sich in der dortigen Grenzschicht 203 an. Defektarten 215 und 217 mit negativer Ladung 216 bewegen sich dagegen zur Elektrode mit positivem Potential (in diesem Fall der zweiten Elektrode 201), um sich in der dortigen Grenzschicht 204 anzulagern. Ladungsträger des Leckstromes $J_{TED}$, welche von einer zu der anderen Elektrode gelangen wollen, müssen Schottky-Barrieren $\phi(t)$ überwinden, welche durch die Grenzschichten 203 und 204 beeinflusst werden. Diese Barrieren haben eine Ausgangsbarrierenhöhe $\phi_0$ und erfahren durch die sich dort ansammelnden Defektarten Barrierenhöhenänderungen $\Delta\phi_i$, welche im weiteren zeitlichen Verlauf zu einer maximalen Barrierenhöhenänderung $\delta\Phi_i$ führen. Die Defektarten erzeugen eine jeweils unterschiedliche Barrierenhöhenänderung $\Delta\Phi_i$.

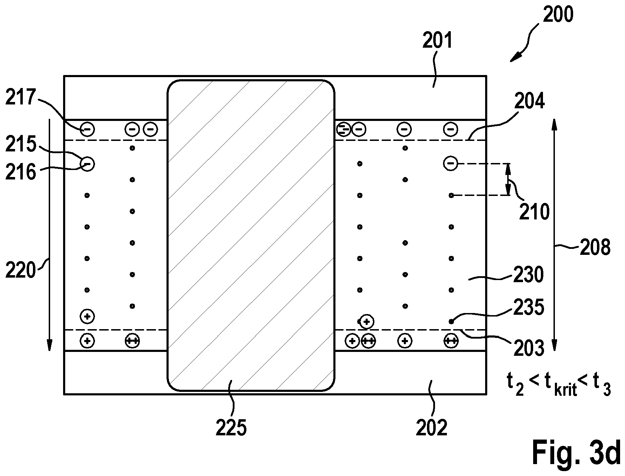

Figur 3c zeigt das Halbleiterbauelement 200 zu einem auf den zweiten Zeitpunkt folgenden dritten Zeitpunkt $t_2$. Hierbei haben sich schon ein Mehrzahl der unterschiedlichen Defektarten 212, 215 und 217 an den Grenzschichten 202 und 203 der dielektrischen Schicht 230 angesammelt und dort für Barrierenhöhenänderungen $\Delta\phi_i$ gesorgt. Zu einem auf den dritten Zeitpunkt folgenden vierten Zeitpunkt $t_3$ wird eine kritische Barrierenhöhe $\phi_{krit}$ an einer der Grenzschichten 202 oder 203 erreicht. Wie auf Figur 3d zu erkennen ist, kommt es hierbei nun zu einem lokalen dielektrischen Durchbruch 225 der dielektrischen Schicht 230. Nach Überschreiten von $t_{krit}$ verbleibt ein Halbleiterbauelement 200, welches lokal auf einer begrenzten Fläche zerstört ist. Mit fortschreitender Belastung bei $t > t_{krit}$ folgen immer weitere lokale dielektrische Durchbrüche 225, was schließlich zur vollständigen Zerstörung des Halbleiterbauelements 200 führt.

**Patentansprüche**

1. Halbleiterbauelement (200), umfassend

   - wenigstens eine dielektrische Schicht (230), und
   - wenigstens eine erste (201) und eine zweite Elektrode (202),

   wobei wenigstens eine erste und eine, sich von der ersten Defektart unterscheidende zweite Defektart in der dielektrischen Schicht (230) vorliegen, wobei sich die wenigstens zwei unterschiedlichen Defektarten (212, 215, 217) in Abhängigkeit einer zwischen der ersten (202) und zweiten Elektrode (201) angelegten Hauptbetriebsspannung und einer vorliegenden Hauptbetriebstemperatur in charakteristischen Zeiten $\tau_1$ und $\tau_2$ an einer der beiden Elektroden (201, 202) ansammeln und an den Elektroden (201, 202) die maximalen Barrierenhöhenänderungen $\delta\Phi_1$ und $\delta\Phi_2$ erzeugen, wobei $\tau_1$ und $\delta\Phi_1$ der ersten Defektart und $\tau_2$ und $\delta\Phi_2$ der zweiten Defektart zugeordnet ist,
   **dadurch gekennzeichnet, dass** $\tau_1 < \tau_2$ und $\delta\Phi_1 < \delta\Phi_2$ gilt.

2. Halbleiterbauelement (200) nach Anspruch 1, **dadurch gekennzeichnet, dass** wenigstens eine weitere dritte Defektart in der dielektrischen Schicht (230) vorliegt, wobei sich die dritte Defektart in Abhängigkeit der zwischen der ersten (202) und zweiten Elektrode (201) angelegten Hauptbetriebsspannung und der vorliegenden Hauptbetriebstemperatur in einer charakteristischen Zeit $\tau_3$ an einer der beiden Elektroden (201, 202) ansammelt und an den Elektroden (201, 202) eine maximale Barrierenhöhenänderung $\delta\Phi_3$ erzeugt, wobei gilt $\tau_1 < \tau_2 < \tau_3$ und wobei die Reihenfolge der Barrierenhöhenänderung von der Reihenfolge $\delta\Phi_1 > \delta\Phi_2 > \delta\Phi_3$ abweicht.

3. Halbleiterbauelement (200) nach einem der Ansprüche 1 oder 2, **dadurch gekennzeichnet, dass** die dielektrische Schicht (230) als polykristallines oxidisches high-k Dielektrikum, insbesondere als PZT-Schicht oder KNN-Schicht ausgebildet ist.

4. Halbleiterbauelement (200) nach einem der Ansprüche 1 bis 3, **dadurch gekennzeichnet, dass** die dielektrische Schicht (230) als gesputterte PZT-Schicht ausgebildet ist.

5. Halbleiterbauelement (200) nach Anspruch 4, **dadurch gekennzeichnet, dass** die gesputterte PZT-Schicht bei einer Abscheidetemperatur von kleiner als 500°C gesputtert wird.

**6.** Halbleiterbauelement (200) nach einem der Ansprüche 4 oder 5, **dadurch gekennzeichnet, dass** die gesputterte PZT-Schicht eine Zusammensetzung von $Pb_x(Zr_{0.52}Ti_{0.48})O_3$ aufweist, wobei $1{,}2 \leq x \leq 1{,}3$ gilt.

**7.** Halbleiterbauelement (200) nach einem der Ansprüche 4 oder 5, **dadurch gekennzeichnet, dass** die gesputterte PZT-Schicht einen Nickelgehalt zwischen 0,1 und 1 Atomprozent aufweist.

**Claims**

**1.** Semiconductor component (200), comprising

- at least one dielectric layer (230), and
- at least one first (201) and one second electrode (202),

wherein at least one first and one second defect type are present in the dielectric layer (230), said second defect type being different from the first defect type, wherein the at least two different defect types (212, 215, 217) accumulate at one of the two electrodes (201, 202) depending on a main operating voltage applied between the first electrode (202) and the second electrode (201) and depending on a prevailing main operating temperature at characteristic times $\tau_1$ and $\tau_2$ and generate the maximum barrier height changes $\delta\Phi_1$ and $\delta\Phi_2$ at the electrodes (201, 202), $\tau_1$ and $\delta\Phi_1$ being assigned to the first defect type and $\tau_2$ and $\delta\Phi_2$ being assigned to the second defect type, **characterized in that** $\tau_1 < \delta\Phi_2$ and $\delta\Phi_1 < \delta\Phi_2$ hold true.

**2.** Semiconductor component (200) according to Claim 1, **characterized in that** at least one further third defect type is present in the dielectric layer (230), wherein the third defect type accumulates at one of the two electrodes (201, 202) depending on the main operating voltage applied between the first electrode (202) and the second electrode (201) and depending on the prevailing main operating temperature at a characteristic time $\tau_3$ and generates a maximum barrier height change $\delta\Phi_3$ at the electrodes (201, 202), wherein $\tau_1 < \tau_2 < \tau_3$ holds true and wherein the order of the barrier height change deviates from the order $\delta\Phi_1 > \delta\Phi_2 > \delta\Phi_3$.

**3.** Semiconductor component (200) according to either of Claims 1 and 2, **characterized in that** the dielectric layer (230) is embodied as a polycrystalline oxidic high-k dielectric, in particular as a PZT layer or a KNN layer.

**4.** Semiconductor component (200) according to any of Claims 1 to 3, **characterized in that** the dielectric layer (230) is embodied as a sputtered PZT layer.

**5.** Semiconductor component (200) according to Claim 4, **characterized in that** the sputtered PZT layer is sputtered at a deposition temperature of less than 500°C.

**6.** Semiconductor component (200) according to either of Claims 4 and 5, **characterized in that** the sputtered PZT layer has a composition of $Pb_x(Zr_{0.52}Ti_{0.48})O_3$, wherein $1.2 \leq x \leq 1.3$ holds true.

**7.** Semiconductor component (200) according to either of Claims 4 and 5, **characterized in that** the sputtered PZT layer has a nickel content of between 0.1 and 1 atom per cent.

**Revendications**

**1.** Composant semi-conducteur (200), comprenant

- au moins une couche diélectrique (230), et
- au moins une première (201) et une deuxième électrode (202),

dans lequel au moins un premier type de défaut et un deuxième type de défaut, différent du premier, sont présents dans la couche diélectrique (230), dans lequel les au moins deux types de défaut différents (212, 215, 217) s'accumulent à l'une des deux électrodes (201, 202) en fonction d'une tension de fonctionnement principale appliquée entre la première (202) et la deuxième électrode (201) et d'une température de fonctionnement principale présente aux temps caractéristiques $\tau_1$ et $\tau_2$ et génèrent aux électrodes (201, 202) les variations de hauteur de barrière maximales $\delta\Phi_1$ et $\delta\Phi_2$, où $\tau_1$ et $\delta\Phi_1$ sont attribués au premier type de défaut et $\tau_2$ et $\delta\Phi_2$ sont attribués au deuxième type de défaut, **caractérisé en ce que** $\tau_1 < \tau_2$ et $\delta\Phi_1 < \delta\Phi_2$.

2. Composant semi-conducteur (200) selon la revendication 1, **caractérisé en ce qu'**au moins un troisième autre type de défaut est présent dans la couche diélectrique (230), dans lequel le troisième type de défaut s'accumule à l'une des deux électrodes (201, 202) en fonction de la tension de fonctionnement principale appliquée entre la première (202) et la deuxième électrode (201) et de la température de fonctionnement principale présente dans un temps caractéristique $\tau_3$ et génère une variation de hauteur de barrière maximale $\delta\Phi_3$ aux électrodes (201, 202), où $\tau_1 < \tau_2 < \tau_3$, et dans lequel l'ordre de la variation de hauteur de barrière diffère de l'ordre $\delta\Phi_1 > \delta\Phi_2 > \delta\Phi_3$.

3. Composant semi-conducteur (200) selon l'une quelconque des revendications 1 ou 2, **caractérisé en ce que** la couche diélectrique (230) est réalisée comme un diélectrique oxydique polycristallin à valeur k élevée, en particulier comme une couche de PZT ou une couche de KNN.

4. Composant semi-conducteur (200) selon l'une quelconque des revendications 1 à 3, **caractérisé en ce que** la couche diélectrique (230) est réalisée comme une couche de PZT pulvérisée.

5. Composant semi-conducteur (200) selon la revendication 4, **caractérisé en ce que** la couche de PZT pulvérisée est pulvérisée à une température de dépôt inférieure à 500 °C.

6. Composant semi-conducteur (200) selon l'une quelconque des revendications 4 ou 5, **caractérisé en ce que** la couche de PZT pulvérisée présente une composition de $Pb_x(Zr_{0,52}Ti_{0,48})O_3$, où $1,2 \le x \le 1,3$.

7. Composant semi-conducteur (200) selon l'une quelconque des revendications 4 ou 5, **caractérisé en ce que** la couche de PZT pulvérisée présente une teneur en nickel comprise entre 0,1 et 1 % en atomes.

EP 3 994 736 B1

Fig. 1a

Fig. 1b

17

Fig. 2a

Fig. 2b

Fig. 2c

Fig. 2d

Fig. 2e

Fig. 3a

$t_0 < t_1 < t_{krit}$

**Fig. 3b**

$t_1 < t_2 < t_{krit}$

**Fig. 3c**

Fig. 3d

$t_2 < t_{krit} < t_3$

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2011074889 A1

- EP 3306687 A1

**In der Beschreibung aufgeführte Nicht-Patentliteratur**

- **C. A. RANDALL ; R. MAIER ; W. QU ; K. KOBAYASHI ; K. MORITA ; Y. MIZUNO ; N. INOUE ; T. OGUNI.** Improved reliability predictions in high permittivity dielectric oxide capacitors under high dc electric fields with oxygen vacancy induced electromigration. *Journal of Applied Physics,* 2013, vol. 113, 014101

- **WANLIN ZHU ; BETUL AKKOPRU-AKGUN ; SUSAN TROLIER-MCKINSTRY.** Highly accelerated lifetime testing of potassium sodium niobate thin films. *Applied Physics Letters,* 2017, vol. 111, 212903

- **P CHAKRABORTI et al.** XPS depth profiling and leakage properties of anodized titania dielectrics and their application in high-density capacitors. *J. Mater. Sei.,* 2015, vol. 50, 7600-7609